# EUROPÄISCHE PATENTSCHRIFT

(11) **EP 1 187 195 B1**
(45) Veröffentlichungstag und Bekanntmachung des Hinweises auf die Patenterteilung: **13.12.2006**
(21) Anmeldenummer: 01121016.8
(22) Anmeldetag: 31.08.2001
(51) Int. Cl.: H01L 21/8234, H01L 27/088, H01L 29/78

(54) **Verfahren zur Herstellung von Feldeffekttransistoren in integrierten Halbleiterschaltungen**
Method of manufacturing field effect transistors in integrated semiconductor circuits
Méthode de fabrication de transistors à effet de champ dans des circuits semi-conducteurs intégrés

(30) Priorität: 12.09.2000 DE 10045045
(43) Veröffentlichungstag der Anmeldung: 13.03.2002
(73) Patentinhaber: Qimonda AG, 81739 München (DE)
(72) Erfinder: Angermann, Wolfgang, 82402 Seeshaupt (DE); Baenisch, Andreas, 81737 München (DE)
(74) Vertreter: Müller - Hoffmann & Partner

(56) Entgegenhaltungen:
- EP-A- 1 056 135
- US-A- 5 188 973
- PATENT ABSTRACTS OF JAPAN Bd. 0120, Nr. 89 (E-592), 23. März 1988 (1988-03-23) & JP 62 224079 A (SONY CORP), 2. Oktober 1987 (1987-10-02)
- PATENT ABSTRACTS OF JAPAN Bd. 0162, Nr. 79 (E-1220), 22. Juni 1992 (1992-06-22) & JP 4 068565 A (FUJITSU LTD), 4. März 1992 (1992-03-04)

## Beschreibung

Die Erfindung betrifft ein Verfahren zur Herstellung von Feldeffekttransistoren, insbesondere MOS-Transistoren, in integrierten Halbleiterschaltungen mit folgenden Schritten:
- Schaffen von voneinander beabstandeten Source- und Drainbereichen eines ersten Leitungstyps in einem Halbleitersubstrat des entgegengesetzten Leitungstyps;
- Schaffen von mehreren Gatebereichen jeweils zwischen einander zugeordneten benachbarten Source- und Drainbereichen, und
- elektrisches Verbinden der jeweiligen zu einem Feldeffekttransistor gehörigen Gatebereiche untereinander, wobei
- die mehreren jeweils zu einem Feldeffekttransistor gehörigen Gatebereiche in Schichten übereinander in bzw. auf dem Halbleitersubstrat in dessen Dickenrichtung gebildet werden, zwischen den übereinander angeordneten Gatebereichen des Transistors eine Halbleiterschicht gebildet wird und jeweils ein Source- und Drainbereich allen übereinanderliegenden Gatebereichen gemeinsam ist.

Für Treibertransistoren in integrierten Halbleiterschaltungen werden sehr häufig MOS-Feldeffekttransistoren verwendet. Größere derartige Feldeffekttransistoren, d. h. Feldeffekttransistoren höherer Leistung, wurden bislang so hergestellt, dass mehrere parallele Gatestreifen fingerförmig in einem Substrat zwischen jeweils zugeordneten Source- und Drainbereichen angeordnet sind.

Dabei konnte ein derartiger für eine höhere Leistung ausgelegter Feldeffekttransistor im Vergleich mit seiner Breitendimension, die z. B. 50 µm beträgt, in seiner lateralen Dimension leicht das Zehnfache messen, z. B. 500 µm.

Im Zuge der Hochintegration integrierter Halbleiterschaltungen ist eine so große Fläche der Treibertransistoren unakzeptabel, und es ist ein Verfahren gewünscht, um den Platzbedarf derartiger Treibertransistoren zu reduzieren.

Im Einzelnen ist aus JP 62 224079 A ein Feldeffekttransistor bekannt, bei dem eine Gateelektrode einen Kanalbereich umgibt und dabei von diesem durch eine Isolierschicht getrennt ist. Das heißt, es liegt hier ein einheitlicher Gatebereich vor, der einen Kanalbereich allseitig umgibt.

Es ist Aufgabe der Erfindung, ein Herstellungsverfahren anzugeben, das es erlaubt, in einer integrierten Halbleiterschaltung größere Feldeffekttransistoren, d. h. Feldeffekttransistoren höherer Leistung, mit verringertem Platzbedarf zu realisieren.

Diese Aufgabe wird bei einem Verfahren der eingangs genannten Art erfindungsgemäß durch die folgenden Schritte gelöst:
- Ausätzen eines Substratabschnitts zwischen zwei einem Feldeffekttransistor zugeordneten Source- und Drainbereichen von einer Hauptfläche des Substrats aus,
- Bilden eines ersten Gatebereichs in dem geätzten Substratabschnitt, so dass der erste Gatebereich zwischen dem Sourcebereich und dem Drainbereich liegt,
- Ausfüllen des geätzten Substratabschnitts oberhalb des ersten Gatebereichs mit Halbleitermaterial,
- Schaffen wenigstens eines zweiten Gatebereichs oberhalb des ersten Gatebereichs unter Zwischenlage des eingefüllten Halbleitermaterials und
- Verbinden der Gatebereiche an wenigstens einer Seite, die von dem Drain- und Sourcebereich freiliegt, mit elektrisch gut leitendem Material.

Es werden also die mehreren, jeweils zu einem Feldeffekttransistor gehörigen Gatebereiche in Schichten übereinander in bzw. auf dem Substrat in dessen Dickenrichtung angeordnet. Das heißt, man geht den Weg in die dritte Dimension anstatt den Transistor in der Ebene der Hauptfläche der integrierten Halbleiterschaltung auszudehnen. Zwischen diesen übereinander angeordneten Gatebereichen liegt jeweils eine Halbleiterschicht, insbesondere eine Siliziumschicht, und ein Sourcebereich auf der einen Seite der Gatebereich und ein Drainbereich auf der anderen Seite sind allen übereinanderliegenden Gatebereichen gemeinsam. Ein derartiges Herstellungsverfahren lässt sich unter Verwendung von im Einzelnen bekannten Prozessschritten ausführen. Zunächst wird innerhalb eines einen Feldeffekttransistor definierenden Substratabschnitts jeweils zwischen einem Sourcebereich und einem zugehörigen Drainbereich von einer Hauptfläche des Substrats ein Abschnitt ausgeätzt. Anschließend wird im Substrat innerhalb des geätzten Abschnitts ein erster Gatebereich geschaffen, so dass dieser erste Gatebereich zwischen den beiden zugehörigen Source- und Drainbereichen liegt. Sodann wird der erste Gatebereich innerhalb des geätzten Substratabschnitts mit Halbleitermaterial, z. B. Silizium überdeckt. Schließlich wird oberhalb des ersten Gatebereichs, d. h. über dem vom Halbleitermaterial überdeckten Bereich desselben, ein zweiter Gatebereich gebildet. Es ist selbstverständlich, dass nicht nur zwei, sondern mehr als zwei Gatebereiche in dieser Weise übereinander angeordnet werden können. Dazu muss die Tiefe der einander zugehörigen Source- und Drainbereiche und die Ätztiefe dazwischen in Dickenrichtung des Substrats entsprechend größer werden. Die zugeordneten Gatebereiche werden anschließend miteinander leitend verbunden.

Bevorzugt ist ein derart hergestellter Feldeffekttransistor ein MOS-Transistor, der den Transistor definierende Substratbereich ist ein p-dotierter Siliziumsubstratbereich und die Drain- und Sourcebereiche bestehen aus n-Silizium.

Die übereinander liegenden Gatebereiche lassen sich in einfacher Weise an wenigstens einer Seite derselben, die vom Drain- und Sourcebereich freiliegt, mit einem elektrisch gut leitenden Material verbinden.

Die obigen erfindungsgemäßen Merkmale zeigen, dass ein mit dem erfindungsgemäßen Verfahren hergestellter Feldeffekttransistor außer dem Vorteil des verringerten Platzbedarfs auf dem Halbleiterchip auch elektrische Kontaktierungen einspart, da nur noch ein Sourcebereich und ein Drainbereich vorhanden sind, so dass keine einander zugehörigen Sourcebereiche oder Drainbereiche miteinander verbunden werden müssen, wie dies im Stand der Technik bislang erforderlich war.

Die Platzeinsparung durch einen mit dem erfindungsgemäßen Verfahren realisierten Feldeffekttransistor in einer integrierten Halbleiterschaltung ist umso größer, je mehr Gatebereiche übereinanderliegend angeordnet sind.

Nachstehend werden ein Ausführungsbeidpiel eines erfindungsgemäßen Herstellungsverfahrens sowie ein damit hergestellter Feldeffekttransistor anhand der Zeichnungen beschrieben.

Es zeigen:
- Fig. 1A bis Fig. 1E: schematisch Prozessschritte des erfindungsgemäßen Verfahrens zur Herstellung eines Feldeffekttransistors in Form von Querschnitten durch einen Abschnitt einer integrierten Halbleiterschaltung;
- Fig. 2: schematisch in ebener Draufsicht einen Substratbereich mit einem in integrierten Halbleiterschaltungen bislang üblichen Feldeffekttransistor, der zwei parallele streifenförmige Gatefinger aufweist; und
- Fig. 3: schematisch den in Fig. 2 gezeigten herkömmlichen Feldeffekttransistor im Querschnitt.

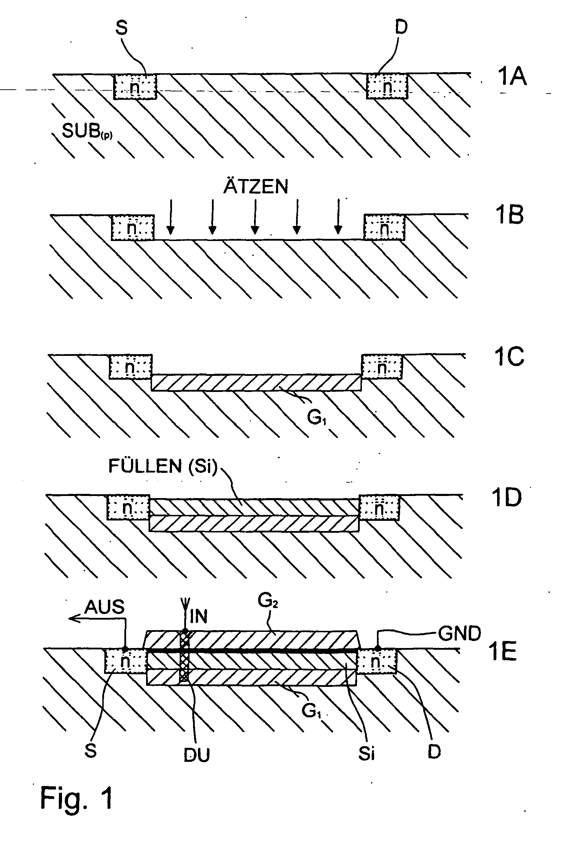

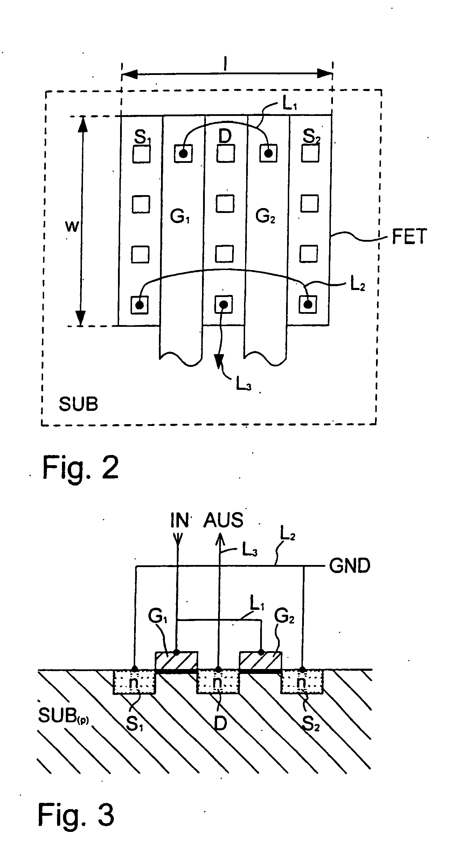

Bevor nun anhand der Fig. 1 ein Ausführungsbeispiel eines erfindungsgemäßen Herstellungsverfahrens und ein damit hergestellter Feldeffekttransistor beschrieben werden, wird zunächst anhand der Fig. 2 und 3 ein Aufbaubeispiel eines bislang in integrierten Halbleiterschaltungen üblichen größeren Feldeffekttransistors erläutert.

In Fig. 2 ist in einem gestrichelt angedeuteten p-leitenden Substratabschnitt SUB ein Feldeffekttransistor FET zu erkennen, bei dem zwei parallele Gatefinger G1, G2 jeweils zwischen einem ersten Sourcebereich S1, einem Drainbereich D und einem zweiten Sourcebereich S2 liegen. Die beiden parallelen Gatefinger G1 und G2 sind miteinander durch eine erste Verbindungsleitung L1 z. B. durch Bondieren einer Drahtleitung an entsprechenden Kontaktflecken elektrisch verbunden. In gleicher Weise sind die beiden Sourcebereiche S1 und S2 durch eine zweite Verbindungsleitung L2 miteinander elektrisch verbunden. Mit dem mittleren Drainbereich ist eine Ausgangsleitung L3 verbunden. Die Weite w eines derartigen Feldeffekttransistors ist aus technologischen Gründen z. B. kleiner oder gleich 50 µm.

Auf die in Fig. 2 dargestellte Weise können auch noch größere Feldeffekttransistoren, d. h. Feldeffekttransistoren höherer Leistung mit mehr als zwei Gatefingern hergestellt werden. Ein derartiger Feldeffekttransistor, der z. B. 10 parallele Gatefinger aufweist, kann eine Längendimension 1 haben, die z. B. 500 µm beträgt, d. h. das Zehnfache der Weite w.

Fig. 3 zeigt den in der ebenen Draufsicht in Fig. 2 veranschaulichten und oben beschriebenen bekannten Feldeffekttransistor im Querschnitt. Die Sourcebereiche S1, S2 und der Drainbereich D bilden n-dotierte Halbleiterbereiche im p-leitenden Substrat SUB. Die Gatefinger G1 und G2 liegen jeweils zwischen diesen Source- und Drainbereichen S1, S2 und D. Die elektrischen Verbindungsleitungen L1, L2 zwischen den beiden Gatefingern G1 und G2 und zwischen den beiden Sourcebereichen S1 und S2 sind ebenfalls aus Fig. 3 ersichtlich. Den Gatefingern G1 und G2 kann ein Eingangssignal IN zugeführt und vom Drainbereich D ein Ausgangssignal AUS abgeführt werden.

Nun wird anhand der Fig. 1 ein Ausführungsbeispiel des erfindungsgemäßen Verfahrens zur Herstellung eines größeren Feldeffekttransistors in einer integrierten Halbleiterschaltung beschrieben, das den oben erwähnten erhöhten Platzbedarf in der integrierten Halbleiterschaltung verringert. Der Grundgedanke der Erfindung besteht in einer Prozessschrittfolge, durch die die Gatebereiche nicht nebeneinander, sondern übereinander gelegt werden, d. h. in Dickenrichtung des Substrats SUB.

Gemäß Fig. 1A wird im p-leitenden Substrat SUB zunächst ein n-dotierter Sourcebereich S und ein n-dotierter Drainbereich D gebildet. Wie nachstehend noch deutlicher wird, entspricht der Abstand zwischen dem Sourcebereich S und dem Drainbereich D der Längendimension des gesamten Feldeffekttransistors. Anschließend wird gemäß Fig. 1B der zwischen S und D liegende Bereich bis zu einer Tiefe geätzt, die es gestattet, mehrere Gatebereiche so übereinander zu legen, dass diese den einen Sourcebereich S und den einen Drainbereich D gemeinsam haben. Gemäß Fig. 1C wird anschließend ein erster Gatebereich G1 in den durch die Ätzung gemäß Fig. 1B ausgeätzten Bereich des Substrats eingebracht. Anschließend wird der erste Gatebereich G1 gemäß Fig. 1B mit einer Siliziumschicht Si bedeckt. Auf dieser Siliziumschicht Si wird dann gemäß Fig. 1E ein zweiter Gatebereich G2 so gebildet, dass er zwischen den Sourcebereich S und dem Drainbereich D zu liegen kommt, d. h. direkt über dem ersten Gatebereich G1. Die beiden übereinanderliegenden Gatebereichen G1 und G2 werden anschließend z. B. durch eine Durchkontaktierung DU elektrisch miteinander verbunden. An der Durchkontaktierung lässt sich außerdem eine das Eingangssignal IN zuführende Leitung anbringen. Am Sourcebereich S kann eine Ausgangsleitung AUS und am Drainbereich D eine Masseleitung GND kontaktiert werden.

Obwohl das oben beschriebene und in Fig. 1 dargestellte Ausführungsbeispiel eines erfindungsgemäßen Herstellungsverfahrens für einen größeren Feldeffekttransistor in einer integrierten Halbleiterschaltung lediglich zwei übereinanderliegende Gatebereiche G1 und G2 beschreibt, ist es dem Fachmann unmittelbar deutlich, dass sich auch mehr als zwei Gatebereiche durch einfache Wiederholung der Schritte gemäß Fig. 1C bis 1E und eine entsprechende Tiefe der Ätzung gemäß Fig. 1B realisieren lassen.

Durch die übereinanderliegende Anordnung mehrerer Gatebereiche eines Feldeffekttransistors lässt sich im Vergleich mit dem bislang üblichen Herstellungsverfahren viel Platz (Chipfläche) sparen, und zwar umso mehr je mehr Gatebereiche übereinander gelegt werden.

Jeder der oben beschriebenen Prozessschritte lässt sich durch in der Herstellung von integrierten Halbleiterschaltungen übliche Verfahrensweisen realisieren.

Ein mit dem in Fig. 1 dargestellten und oben beschriebenen Verfahren hergestellter Feldeffekttransistor kann z. B. ein MOS-Feldeffekttransistor sein, der, wie bislang übliche Feldeffekttransistoren, eine rechteckige Form hat. Statt der in Fig. 1E gezeigten die elektrische Verbindung der Gatebereiche G1 und G2 herstellenden Durchkontaktierung DU können auch andere Kontaktierungsverfahren eine oder beide vom Sourcebereich S und Drainbereich D freiliegende Seiten der Gatebereiche miteinander verbinden.

## Patentansprüche

1. Verfahren zur Herstellung von Feldeffekttransistoren, insbesondere MOS-Transistoren, in integrierten Halbleiterschaltungen mit folgenden Schritten:
- Schaffen von voneinander beabstandeten Source- und Drainbereichen (S, D) eines ersten Leitungstyps (n) in einem Halbleitersubstrat (SUB) des entgegengesetzten Leitungstyps (p);
- Schaffen von mehreren Gatebereichen (G) jeweils zwischen einander zugeordneten benachbarten Source- und Drainbereichen (S, D), und
- elektrisches Verbinden der jeweiligen zu einem Feldeffekttransistor gehörigen Gatebereiche (G1, G2) untereinander, wobei
- die mehreren jeweils zu einem Feldeffekttransistor gehörigen Gatebereiche (G1, G2) in Schichten übereinander in bzw. auf dem Halbleitersubstrat (SUB) in dessen Dickenrichtung gebildet werden, zwischen den übereinander angeordneten Gatebereichen (G1, G2) des Transistors eine Halbleiterschicht gebildet wird und jeweils ein Source- und Drainbereich allen übereinanderliegenden Gatebereichen gemeinsam ist,
**gekennzeichnet durch** folgende Schritte:
- Ausätzen eines Substratabschnitts zwischen zwei einem Feldeffekttransistor zugeordneten Source- und Drainbereichen (S, D) von einer Hauptfläche des Substrats (SUB) aus;
- Bilden eines ersten Gatebereichs (G1) in dem geätzten Substratabschnitt (SUB), so dass der erste Gatebereich (G1) zwischen dem Sourcebereich (S) und dem Drainbereich (D) liegt;
- Ausfüllen des geätzten Substratabschnitts oberhalb des ersten Gatebereichs (G1) mit Halbleitermaterial (Si);
- Schaffen wenigstens eines zweiten Gatebereichs (G2) oberhalb des ersten Gatebereichs (G1) unter Zwischenlage des eingefüllten Halbleitermaterials (Si) und
- Verbinden der Gatebereiche (G1, G2) an wenigstens einer Seite, die von dem Drain- und Sourcebereich (D, S) freiliegt, mit elektrisch gut leitendem Material.

2. Verfahren nach Anspruch 1,
**dadurch gekennzeichnet,**
**dass** ein den Feldeffekttransistor enthaltender Substratabschnitt ein p-dotierter Siliziumsubstratabschnitt ist, und dass die Drain- und Sourcebereiche n-Silizium und der Bereich zwischen einander zugeordneten benachbarten Source- und Drainbereichen SiO₂ aufweist.

## Claims

1. Method for fabricating field-effect transistors, in particular MOS transistors, in integrated semiconductor circuits, having the following steps:
- production of mutually spaced-apart source and drain regions (S, D) of a first conduction type (n) in a semiconductor substrate (SUB) of the opposite conduction type (p);
- production of a plurality of gate regions (G) in each case between mutually assigned adjacent source and drain regions (S, D), and
- electrical interconnection of the respective gate regions (G1, G2) associated with a field-effect transistor,
- the plurality of gate regions (G1, G2) respectively associated with a field-effect transistor being formed in layers one above the other in and/or on the semiconductor substrate (SUB) in the thickness direction thereof, a semiconductor layer being formed between the gate regions (G1, G2) of the transistor that are arranged one above the other, and a source and drain region in each case being common to all the gate regions lying one above the other,
**characterized by** the following steps:
- etching-out of a substrate section between two source and drain regions (S, D) assigned to a field-effect transistor, from a main area of the substrate (SUB);
- formation of a first gate region (G1) in the etched substrate section (SUB), with the result that the first gate region (G1) lies between the source region (S) and the drain region (D);
- filling of the etched substrate section above the first gate region (G1) with semiconductor material (Si);
- production of at least a second gate region (G2) above the first gate region (G1) with the interposition of the filled-in semiconductor material (Si), and
- connection of the gate regions (G1, G2) on at least one side which is free of the drain and source region (D, S), to readily electrically conductive material.

2. Method according to Claim 1,
**characterized**
**in that** a substrate section containing the field-effect transistor is a p-doped silicon substrate section, and in that the drain and source regions have n-type silicon and the region between mutually assigned adjacent source and drain regions has SiO₂.

## Revendications

1. Procédé de fabrication de transistors à effet de champ, notamment de transistors MOS dans des circuits à semiconducteurs intégrés, comprenant les stades suivants dans lesquels :
- on ménage des zones (SD) de source et de drain à distance les unes des autres d'un premier type (n) de conductivité dans un substrat (SUB) semiconducteur du type (p) de conductivité opposé :
- on ménage plusieurs zones (G) de grille respectivement entre des zones (S, D) de source et de drain voisines associées l'une à l'autre et
- on relie électriquement entre elles les zones (G1, G2) de grille respectives associées à un transistor à effet de champ, dans lequel :
- on forme plusieurs zones (G1, G2) de grille appartenant respectivement à un transistor à effet de champ en des couches les unes sur les autres dans ou sur le substrat (SUB) semiconducteur dans sa direction d'épaisseur,
- on forme entre les zones (G1, G2) des deux grilles du transistor disposées les unes sur les autres une couche semi conductrice et respectivement une zone de source et une zone de drain de toutes les zones de grille superposées est commune,
**caractérisé par** des stades suivants :
- on enlève par attaque une partie du substrat entre deux zones (S, D) de source et de drain associées à un transistor à effet de champ d'une surface principale du substrat (SUB) ;
- on forme une première zone, (Gl)de grille dans la partie (SUB) de substrat attaquée, de manière à ce que la première zone (G1) de grille se trouve entre la zone (S) de source et la zone (D) de drain ;
- on remplit la partie du substrat attaqué au dessus de la première zone (G1) de grille de matériau (Si) semi conducteur
- on ménage au moins une deuxième zone (G2) de grille au dessus de la première zone (G1) de grille avec interposition du matériau (Si) semiconducteur de remplissage et
- on relie les zones (G1, G2) de grille sur au moins un côté, qui est dégagé de la zone (D, S) de drain et de source, d'un matériau bon conducteur de l'électricité.

2. Procédé suivant la revendication 1,
- **caractérisé**
- **en ce qu'**une partie du substrat contenant un transistor à effet de champ est une partie de substrat à dopage (p) et en ce que les zones de drain et de source ont du silicium (n) et la zone comprise entre des zones de source et de drain voisinent associées l'une à l'autre a du (SiO₂).
